# EUROPEAN PATENT APPLICATION

(11) **EP 4 694 594 A1**
(43) Date of publication of application: **11.02.2026**
(21) Application number: 25194427.8
(22) Date of filing: 06.08.2025
(51) Int. Cl.: H05K 5/06

(54) **SEALED ELECTRICAL FEEDTHROUGH**

(30) Priority: 07.08.2024 US 202418796581
(71) Applicant: ABB SCHWEIZ AG, 5400 Baden (CH)
(72) Inventor: SMITH, Brian C., Tulsa, 74104 (US); ROBERTSON, Brian J., Tulsa, 74134 (US)
(74) Representative: Maiwald GmbH

(57) **Abstract**

The invention provides an explosion resistant electrical fitting, including a cylindrical body, a sealing ring, a locking element, and a printed circuit board (PCB). The cylindrical body includes a first end, a second end opposite the first end, an interior cavity extending from the first end to the second end, a shoulder at the second end protruding radially outward relative to a central axis, and a threaded surface. The sealing ring is arranged about the cylindrical body between the threaded surface and the shoulder of the cylindrical body. The locking element is arranged at the first end. The PCB is arranged in the interior cavity of the cylindrical body.

## Description

### FIELD

The present disclosure relates to an electrical feedthrough that forms a seal between chambers, and systems and methods for providing such a sealed electrical feedthrough.

### BACKGROUND OF THE INVENTION

Sealed feedthroughs are required in systems and devices in which hazardous materials, such as flammable or combustible liquids and/or gasses, are arranged. Such sealed feedthroughs prevent leakage of the hazardous materials. Ideally, however such sealed feedthroughs are further configured not only to prevent leakage at nominal pressures, but also to prevent passage of the hazardous material through the sealed feedthrough when it experiences a spike in pressure. Such a pressure spike can be caused, for example, when the hazardous material combusts and causes an explosion in a chamber sealed by the feedthrough. Sealed feedthroughs are thus employed between chambers in which at least one of the chambers includes the hazardous material.

Sealed feedthroughs are also known to include electrical connections between sealed chambers, thereby enabling electrical signals to be passed through the fitting without compromising the seal. To accomplish this, electrical wires are conventionally passed through a fitting and integrated into the fitting via a sealing material, such as a resin. In order to ensure that the sealing material properly fills all gaps between and around wires, extensive manual labor is often required. Manual filling of a feedthrough with resin can be difficult and tedious, particularly for feedthroughs arranged in tight spaces and/or spaces that are difficult to access or that are exposed to harsh conditions that may be unsafe for a human worker.

In view of the foregoing, what is needed is an improved sealed electrical feedthrough and methods for implementing the same.

### BRIEF SUMMARY OF THE INVENTION

The invention provides an explosion resistant electrical fitting, comprising a cylindrical body, a sealing ring, a locking element, and a printed circuit board (PCB). The cylindrical body includes a first end, a second end opposite the first end, an interior cavity extending from the first end to the second end, a shoulder at the second end protruding radially outward relative to a central axis, and a threaded surface. The sealing ring is arranged about the cylindrical body between the threaded surface and the shoulder of the cylindrical body. The locking element is arranged at the first end. The PCB is arranged in the interior cavity of the cylindrical body.

### BRIEF DESCRIPTION OF THE SEVERAL VIEWS OF THE DRAWINGS

FIG. 1 illustrates a perspective view of a sealed electrical feedthrough;
FIG. 2 illustrates a cross-sectional side view of the sealed electrical feedthrough;
FIG. 3 illustrates a perspective view of the first or top end of the sealed electrical feedthrough;
FIG. 4 illustrates a top-down view of a first or top end of the sealed electrical feedthrough; and
FIG. 5 illustrates a bottom-u[ view of a second or bottom end of the sealed electrical feedthrough.

### DETAILED DESCRIPTION OF THE INVENTION

Embodiments of the present disclosure provide an improved sealed electrical feedthrough that is not only explosion-resistant, but also provides for feedthrough of electrical signals via a printed circuit board (PCB). The sealed electrical feedthrough is configured for arrangement between two chambers and is integrated into a wall of a housing between the two chambers. The PCB of the sealed electrical feedthrough is preconfigured with explosion-resistant properties, such as a resin coating, and pre-arranged in a cylindrical body of the sealed electrical feedthrough. The foregoing features allow the sealed electrical feedthrough to be assembled prior to installation, thereby significantly reducing the difficulty of installation and eliminating the need to add a sealing material in the sealed electrical feedthrough. In addition, the need for arranging and manipulating wires in the sealed electrical feedthrough is eliminated, as the PCB replaces wires that would otherwise be used for electrical feedthrough in conventional solutions.

The sealed electrical feedthrough can include a threaded surface configured to engage with corresponding threads in the housing. This allows the sealed electrical feedthrough to be easily arranged in the housing by rotation of the sealed electrical feedthrough in accordance with the configuration of the threads. The overall length of the threads of the sealed electrical feedthrough and the housing are configured to ensure that the strength of threaded engagement of the sealed electrical feedthrough with the housing is sufficient to withstand a pressure spike within one of the chambers up to a threshold pressure. The threshold pressure can be, for example, up to 1,000 pounds per square inch (psi).

Furthermore, the threads of the sealed electrical feedthrough and housing can be configured to provide for extra rotation of the sealed electrical feedthrough beyond a threaded engagement depth that would provide sufficient engagement to withstand the threshold pressure. The sealed electrical feedthrough can then be counter-rotated to undo the threaded engagement slightly, thereby allowing the sealed electrical feedthrough to be arranged at a predictable rotational position while maintaining its explosion resistance (e.g., resistance up to the threshold pressure).

The predictable rotational position is provided by inclusion of a locking element on the sealed electrical feedthrough with a first locking tab that is received into a recess in the cylindrical body. The locking element can thereby be attached to the cylindrical body of the sealed electrical feedthrough with a predictable orientation (e.g., an orientation that is consistent across discrete sealed electrical feedthroughs). The locking element includes a protruding tab (also referred to herein as a second locking tab) configured to be received in a recess within the housing. The locking element, and thereby the sealed electrical feedthrough as a whole, can thus be secured with a known rotational orientation within the housing. This process, referred to as "clocking," reduces the need for complex manual labor for installation, and thereby reduces training requirements for installers. Moreover, because the known rotational orientation is also known to provide sufficient threaded engagement of the sealed electrical feedthrough in the housing to provide a required explosion resistance, the sealing performance of the sealed electrical feedthrough is assured when installed in the housing. The locking element can be configured as a washer that surrounds a portion of the cylindrical body.

The sealed electrical feedthrough can also include electrical interfaces connected on either side of the PCB (e.g., on both a first side facing a first of the chambers and a second side facing a second of the chambers). Electrical signals can be passed to the PCB to/from either side of the PCB for full electrical integration of the PCB with sensors and or processors arranged in either chamber (or both chambers). Moreover, the PCB acts as an electrical bridge that bridges electrical conductors in both chambers.

The disclosed sealed electrical feedthrough can be installed in a variety of conditions and/or applications without departing from the spirit of the present disclosure. For example, the sealed electrical feedthrough can be installed in a gas chromatograph in various applications, such as natural gas or oil extraction, refinement, and/or processing. In such applications, it is essential that a sealed electrical feedthrough provide explosion resistance in accordance with standards set forth by regulation, industrial organizations, and/or internal policy/procedure. The sealed electrical feedthrough according to the present disclosure thus provides for safe monitoring or receiving of chromatograph measurements through the feedthrough without compromising explosion resistance of structures between the chambers.

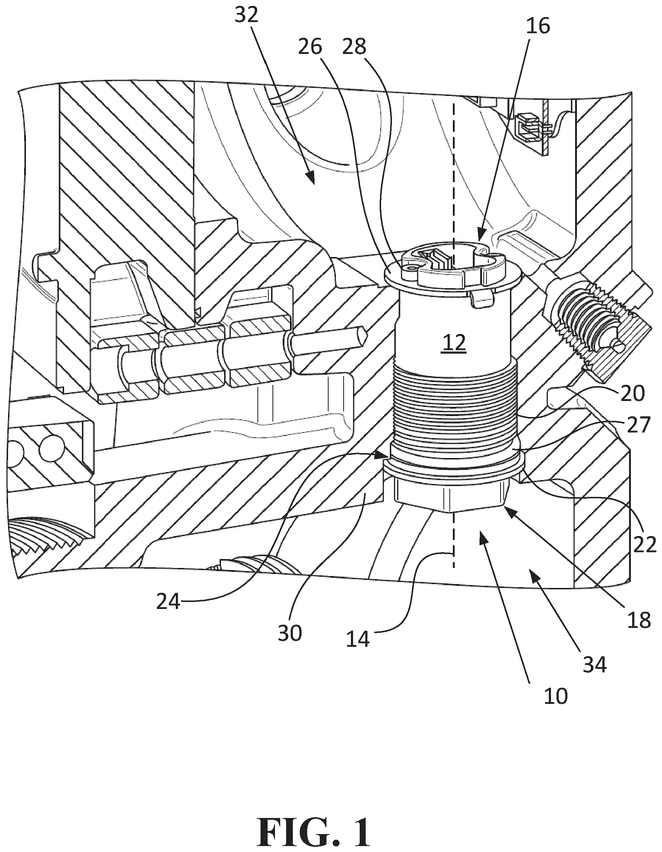

FIG. 1 illustrates a perspective view of a sealed electrical feedthrough 10 formed as an explosion-resistant electrical fitting. The sealed electrical feedthrough 10 includes a cylindrical body 12 with a central axis 14, a first end 16 at one axial end, and a second end 18 opposite the first end 16 at another axial end. A threaded surface 20 is included on at least part of an outer periphery of the cylindrical body 12. The threaded surface 20 is configured to engage with a corresponding threaded surface of a housing 30 that separates a first chamber 32 from a second chamber 34. The threaded engagement of the threaded surface 20 with the housing 30 allows the sealed electrical feedthrough 10 to be easily arranged within the housing 30 by rotating the sealed electrical feedthrough 10 around the central axis 14 in accordance with a direction of threads of the threaded surface 20. For example, cylindrical body can be inserted into the opening in the housing between the first and second chambers 32, 34 by rotating it clockwise (when viewed upward from the bottom to the top along the central axis 14 in accordance with FIG. 1) such that the cylindrical body 12 gradually moves axially into the housing 30 as it is rotated.

The cylindrical body 12 includes a shoulder 22 that extends radially outward relative to the central axis 14 and extends away from the outer periphery of the remainder of the cylindrical body 12. The shoulder 22 is configured to abut a shoulder stop 24, which is a surface of the housing 30 defining an opening that has a diameter that is less than an outer diameter of the shoulder 22. Because the shoulder 22 has a larger outer diameter than the opening formed by the shoulder stop 24, the shoulder stop 24 prevents the sealed electrical feedthrough 10 from being rotated beyond a certain point along the threaded surface 20. In other words, the shoulder stop 24 limits the depth at which the sealed electrical feedthrough 10 can be inserted into the housing 30. The shoulder stop 24 also advantageously provides for simplified installation of the sealed electrical feedthrough 10 within the housing 30 by providing a physically perceivable and/or detectable rotational resistance when the sealed electrical feedthrough 10 is fully inserted during an installation process. As a result, a person installing the sealed electrical feedthrough 10 in the housing 30 can easily detect when the sealed electrical feedthrough 10 has been inserted into the housing 30 at its maximum insertion depth. From this maximum insertion depth, the sealed electrical feedthrough 10 can be counter-rotated (i.e., rotated in an opposite rotational direction than initially used to engage the threads and insert the sealed electrical feedthrough 10 in the housing 30) to a known and predictable orientation so that an installation can be successfully and consistently achieved in accordance with applicable standards. For example, the sealed electrical feedthrough 10 is configured to comply with Underwriters Laboratories (UL) 1203 for explosion-proof and dust-ignition-proof electrical equipment, Canadian Standards Association (CSA) CS22.2 No. 30:20 for explosion-proof equipment, and International Electrotechnical Commission (IEC) 60079 for equipment in potentially hazardous areas. The Classified Hazardous Location listings are as follows: ATEX/IECEx - Ex db IIB+H2 T6 GB, North America - CID2 Grp BCD T6.

The sealed electrical feedthrough 10 also includes a sealing ring 27 arranged between the threaded surface 20 and the shoulder 22. The sealing ring 27 is arranged about an outer circumferential periphery of the cylindrical body 12. When the sealed electrical feedthrough 10 is installed in the housing 30, the sealing ring 27 is also arranged between an inner circumferential surface of the housing 30 and the outer circumferential periphery of the sealed electrical feedthrough 10, thereby forming a seal between them and facilitating sealing of the first chamber 32 from the second chamber 34 by the sealed electrical feedthrough 10 as a whole. The seal between the first and second chambers 32, 34 is further formed by inclusion of sealing materials arranged within the cylindrical body 12. For example, epoxy resin can be used as a sealing material to fill empty space between the first end 16 and second end 18 within an interior cavity of the cylindrical body 12. The epoxy resin can include commercially available resins that are compliant with requirements set forth by certifying agencies for explosion-resistant applications. For example, the epoxy resin can be EP41S-6 sold by Master Bond Inc., headquartered in Hackensack, New Jersey, or Loctite^{®} E-40EXP sold by Henkel, headquartered in Dusseldorf, Germany.

A locking element 26 is arranged at the first end 16 of the cylindrical body 12. The locking element 26 is attached to the cylindrical body 12 by fasteners 28, and can thereby be selectively attached to or detached from the cylindrical body 12. In the illustrated embodiment, the fasteners 28 include threaded bolts. It will be readily appreciated that the fasteners 28 can have a different appearance and/or configuration from the bolts illustrated in FIG. 1 without departing from the spirit of the present disclosure. For example, the fasteners 28 can comprise bolts of various shape, thread length, thread pitch, and the like. Moreover, the fasteners 28 can be embodied as screws, nails, clips, rivets, and the like. The fasteners 28 ensure that the locking element 26 is rigidly attached to the cylindrical body 12 in a known rotational orientation.

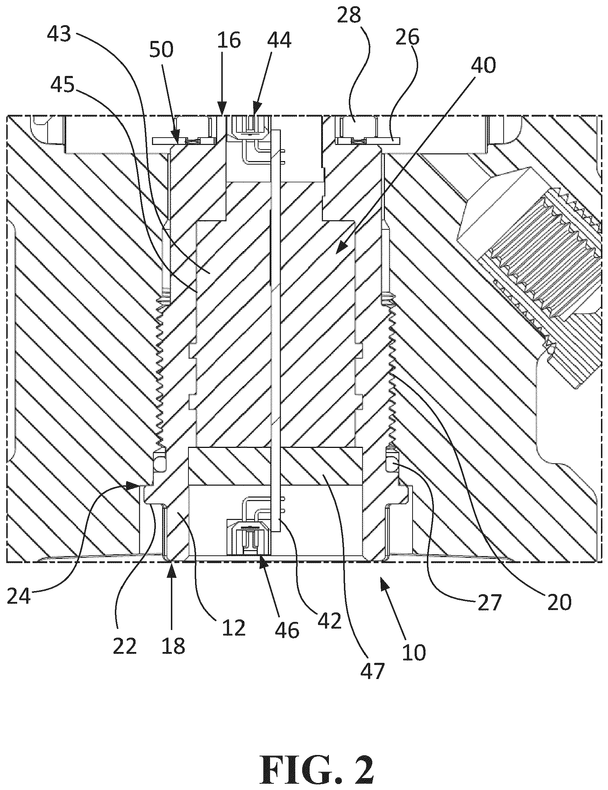

A PCB is arranged in the interior cavity of the cylindrical body 12 (as will be shown hereafter in FIG. 2). Electrical interfaces connected to the PCB are also arranged at both the first end 16 and the second end 18. Corresponding electrical interfaces for connecting to the electrical interfaces of the PCB can be arranged within the first and second chambers 32, 34. Conductors arranged in the first chamber 32 can thereby be connected to the PCB at the first end 16, and conductors arranged in the second chamber 34 can thereby be connected to the PCB at the second end 18.

FIG. 2 illustrates a cross-sectional side view of the sealed electrical feedthrough 10. The cylindrical body 12 has an internal cavity 40 in which a PCB 42 is arranged. The PCB 42 is rigidly secured to the cylindrical body 12. For example, the PCB 42 can be rigidly secured within the internal cavity 40 by means of a body of resin 43 formed in the space surrounding the PCB 42 that represents a gap between the PCB 42 and a radially interior wall 45 of the cylindrical body 12. The PCB 42 can also be at least partially held in place within the cylindrical body 12 by a potting dam 47, which can be held in place by friction with the PCB 42 and the radially interior wall 45 of the cylindrical body 12. In particular, the potting dam 47 can be sized to have a diameter or radially outer periphery that is slightly larger than the diameter or inner radial periphery of the internal cavity 40 of the cylindrical body 12, thereby resulting in compressive forces that not only hold the potting dam 47 in place, but also cause the potting dam 47 to hold the PCB 42 in place. The potting dam 47 can be formed of silicon rubber and is configured to dam up resin 43 inserted into the internal cavity 40, thereby preventing the resin 43 from flowing out of the internal cavity through the second end 18 when in a liquid state and ensuring that the resin 43 cures throughout the internal cavity 40 in a manner delimited by the potting dam 47.

The illustrated embodiment of FIG. 2 can be produced by first inserting the PCB 42 in the potting dam 47. The PCB 42 and potting dam 47 are then inserted together into the cylindrical body 12 via the second end 18. This allows the PCB 42 to be held in place while a resin 43 is poured or injected into the internal cavity 40. Once the resin 43 hardens, the PCB 42 is rigidly secured within the cylindrical body 12. It will be readily appreciated that other structures can be implemented to secure the PCB 42 within the internal cavity 40 of the cylindrical body 12 without departing from the spirit of the present disclosure. For example, other fasteners, such as screws, bolts, standoffs, rivets, welds, or solder, can be used to secure the PCB 42 to the cylindrical body 12 within the internal cavity. In any case, however, resin 43 is used to fill voids within the internal cavity 40 so than the first chamber 32 and second chamber 34 are completely sealed from one another upon arrangement of the sealed electrical feedthrough 10 within the housing 30.

The PCB 42 can be pre-configured with explosion-resistant properties prior to its attachment to the cylindrical body 12. The PCB 42 can be inspected for cleanliness prior to installation in order to ensure compliance with explosion-resistance standards, and can include materials of a high quality and/or grade. For example, the PCB 42 can include FR4 grade material as set forth by the National Electrical Manufacturers Association (NEMA). In particular, the PCB 42 can include FR4 grade A1 or A2 as set forth by NEMA. The PCB 42 can include a glass fiber epoxy laminate. A first electrical interface 44 is connected to the PCB 42 and arranged at the first end 16 of the sealed electrical feedthrough 10. A second electrical interface 46 is arranged at the second end 18 of the sealed electrical feedthrough 10. The first and second electrical interfaces 44, 46 thus enable the PCB 42 to electrically bridge conductors within both chambers 32, 34. In an exemplary application, the housing can be part of a gas chromatograph and a sensor can be arranged within-or electrically connected to conductors within-the first chamber 32. The sealed electrical feedthrough 10 thereby allows signals from the sensor arranged within the first chamber 32 to be received and processed either by the PCB 42 of the sealed electrical feedthrough 10 itself, or by a processor arranged outside of the first chamber 32 (e.g., within the second chamber 34 or externally via electrical connection to the second chamber). The electrical feedthrough provided by the sealed electrical feedthrough 10 is accomplished without compromising explosion-resistant performance.

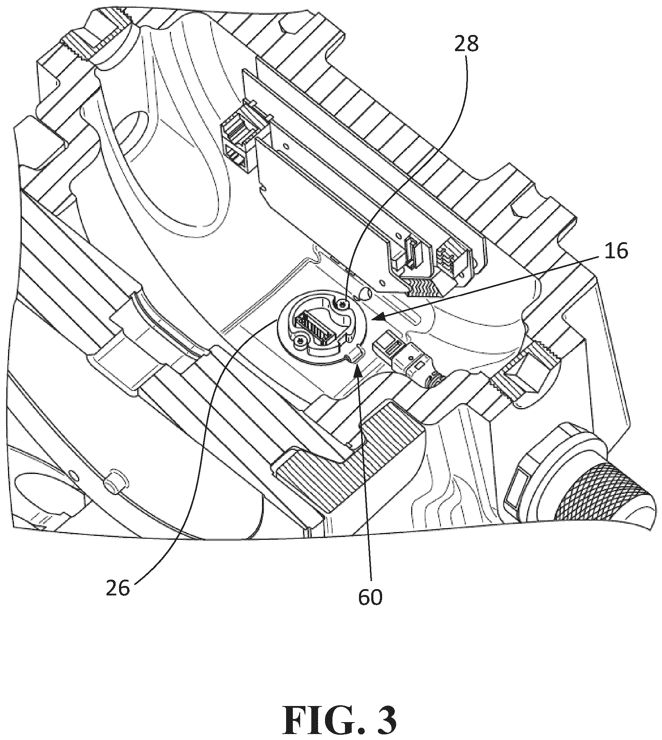

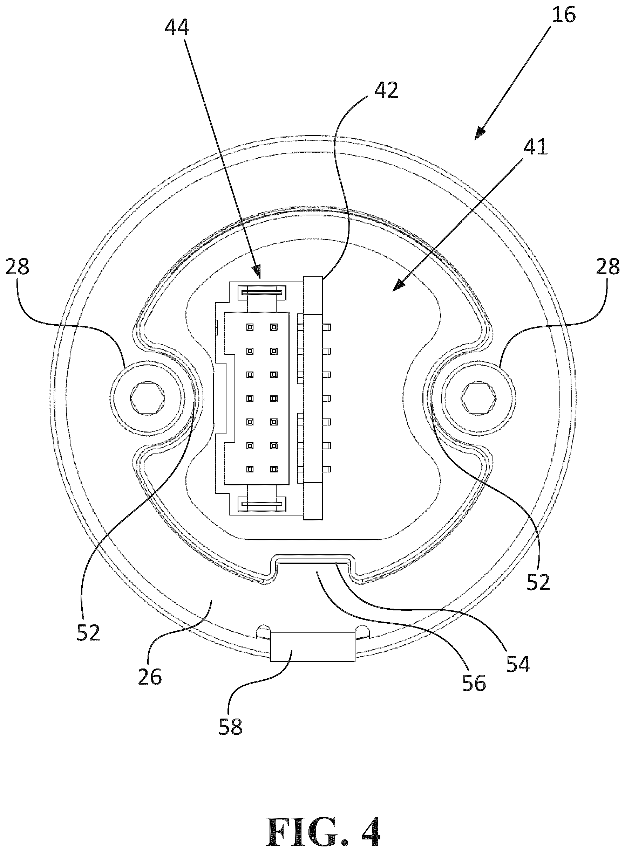

FIG. 3 illustrates a perspective view of the first end 16 (also referred to herein as the top end) of the sealed electrical feedthrough 10, and FIG. 4 illustrates a top-down view of the same (e.g., from top looking downward with reference to how the sealed electrical feedthrough 10 is oriented in FIG. 1). The locking element 26 is arranged against the locking element surface 50 as illustrated in FIG. 2. The locking element surface 50 includes openings extending toward the second end 18 of the cylindrical body 12 and through the cylindrical body. The fasteners 28 can be arranged in the openings to secure the locking element 26 against the locking element surface 50. The first end 16 of the cylindrical body 12 includes two recesses 52 that are diametrically opposed to one another across the axial opening 41 of the cylindrical body 12 leading into its interior cavity 40. The recesses 52 provide space for the fasteners 28. The cylindrical body 12 also includes a locking element recess 54 at the first end 16. The locking element recess 54 extends radially inward relative to a radially outer periphery of the cylindrical body 12 of the first end 16. The locking element recess 54 is configured to receive a correspondingly shaped first locking tab 56 of the locking element 26.

In the illustrated embodiment, the locking element recess 54 and the first locking tab 56 have a rectangular shape, and the first locking tab 56 extends radially inward toward the central axis of the cylindrical body 12. The first locking tab 56 is configured to fit in a form-fitting manner in the locking element recess 54. As a result of the first locking tab 56 being arranged in the locking element recess 54, the locking element 26 is rotationally constrained relative to the cylindrical axis. In other words, the locking element 26 is prevented from moving relative to the cylindrical body 12 in a circumferential direction about the central axis. The fasteners 28 further axially constrain the locking element 26, which in combination with the locking element recess 54 thereby fully fixes and constrains the locking element 26 to the cylindrical body 12 such that there is no relative movement between them. It will be readily appreciated that the particular shape of the first locking tab 56 and the locking element recess 54 can vary from that illustrated in FIG. 4 without departing from the spirit of the present disclosure, as long as they provide for rotational fixing of the locking element 26 relative to the cylindrical body 12.

The locking element 26 also includes a second locking tab 58 that protrudes radially outward relative to the central axis of the cylindrical body 12 and axially relative to the central axis, thereby forming a right angle. The axial protrusion of the second locking tab 58 is toward the second end 18 of the cylindrical body 12 when the locking element 26 is fixed to the cylindrical body 12. A locking tab recess 60 is arranged in the housing 30 on the locking element surface 50. The locking tab recess 60 is configured to receive the second locking tab 58 such that movement of the locking element 26 becomes constrained. As a result, when the locking element 26 is fixed to the cylindrical body 12, engagement of the second locking tab 58 in the locking tab recess 60 prevents the cylindrical body 12 from being rotated in any direction within threads of the housing 30 that would allow the sealed electrical feedthrough 10 to be moved in or out of the housing 30. The combination of the cylindrical body 12, locking element 26, fasteners 28, and the locking tab recess 60 thus ensure that the sealed electrical feedthrough 10 can be inserted into the housing 30 securely.

As illustrated in FIG. 4, the first electrical interface 44 can be connected to the PCB 42 and provide for electrical connection to a corresponding interface via a plurality of pins. For example, in the illustrated embodiment, the first electrical interface 44 comprises a 14-pin female connector. The first electrical interface 44 can be a standardized and/or commercially available connector in order to reduce costs and provide for wide compatibility with other commercially available electrical products with corresponding connectors. It will be readily appreciated that the first electrical interface 44 can include more pins or fewer pins, and can be a male connector, a female connector, or a combination of both without departing from the spirit of the present disclosure. The first electrical connector 44 can be connected both physically and electrically to the PCB 42 via pins (e.g., straight-pins or right angle pins) and/or solder.

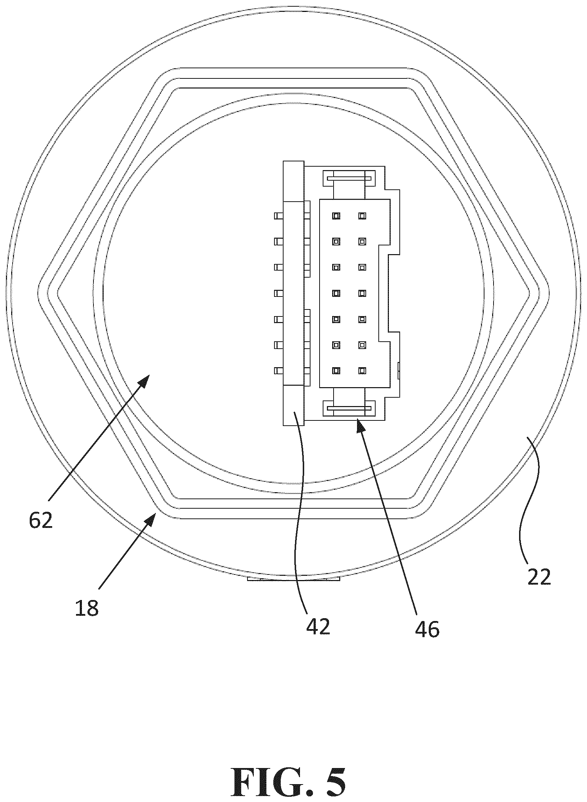

FIG. 5 illustrates a bottom view of the second end 18 of the sealed electrical feedthrough 10. The second end 18 includes an opening 62 leading to the internal cavity of the cylindrical body 12. An electrical interface is arranged at the second end 18 that is connected to the PCB 42 arranged within the internal cavity of the cylindrical body 12. Although FIG. 5 illustrates a second end 18 having a hexagonally shaped outer periphery, it will be readily appreciated that the second end 18 can have a variety of shapes and/or sizes without departing from the spirit of the present disclosure. For example, the outer periphery of the second end 18 can be any polygonal shape, or can be circular or irregular in shape. Whereas the first end 16 of the cylindrical body 12 has a particular shape and various features that are specifically configured for the purpose of securely fixing the sealed electrical feedthrough 10 in the housing 30, the purpose of the second end 18, in contrast, is primarily to provide an opening through which electrical connection can be made from the second chamber 34 to the PCB 42.

An embodiment of the present disclosure is also directed to a method for providing an explosion-resistant electrical fitting between the first and second chambers 32, 34. As illustrated in FIGS. 1 and 2, the cylindrical body 12 is provided with a threaded surface 20 and a shoulder 22 that protrudes radially outward relative to the central axis 14. A PCB is arranged within the cylindrical body 12 and the sealing ring 27 is arranged about a circumferential periphery of the cylindrical body 12. The cylindrical body 12 is inserted into a threaded bore of the housing 30 between the first and second chambers 32, 34 by rotating the cylindrical body 12 such that the threaded surface 20 engages with the threaded bore. The cylindrical body 12 is rotated in a first rotational direction (e.g., a rotational direction that causes the cylindrical body 12 to be inserted deeper into the housing 30 due to the threaded configuration of the cylindrical body 12 and threaded bore) until the shoulder 22 of the cylindrical body 12 contacts the shoulder stop 24 formed at one end of the threaded bore.

The method can further include fixing the locking element 26 to the cylindrical body 12 at a position opposing the shoulder 22 such that the locking element 26 is rotationally fixed to the cylindrical body 12, or in other words, such that the locking element 26 cannot rotate relative to the cylindrical body 12. The locking element 26 can include a locking tab (e.g., the second locking tab 58 of FIGS. 3 and 4) that is configured to engage a locking tab recess 60 within the first chamber 32 (or in the second chamber 34, if the design of the housing 30 is reversed). The cylindrical body 12 is rotated in a second rotational direction opposite the first rotational direction (e.g., a rotational direction that causes the cylindrical body 12 to be extracted from the housing 30 due to the threaded configuration of the cylindrical body 12 and threaded bore) until the locking tab is inserted into the locking tab recess 60.

The method can further include electrically connecting first conductors in the first chamber 32 to a PCB 42 of the sealed electrical feedthrough 10 and connecting second conductors in the second chamber 34 to the PCB 42. Input signals can be received from one of the first and second conductors to the PCB 42. Output signals can be transmitted based on the received input signals to the other of the first and second conductors via the PCB 42.

All references, including publications, patent applications, and patents, cited herein are hereby incorporated by reference to the same extent as if each reference were individually and specifically indicated to be incorporated by reference and were set forth in its entirety herein.

The use of the terms "a" and "an" and "the" and "at least one" and similar referents in the context of describing the invention (especially in the context of the following claims) are to be construed to cover both the singular and the plural, unless otherwise indicated herein or clearly contradicted by context. The use of the term "at least one" followed by a list of one or more items (for example, "at least one of A and B") is to be construed to mean one item selected from the listed items (A or B) or any combination of two or more of the listed items (A and B), unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed. No language in the specification should be construed as indicating any non-claimed element as essential to the practice of the invention.

Preferred embodiments of this invention are described herein, including the best mode known to the inventors for carrying out the invention. Variations of those preferred embodiments may become apparent to those of ordinary skill in the art upon reading the foregoing description. The inventors expect skilled artisans to employ such variations as appropriate, and the inventors intend for the invention to be practiced otherwise than as specifically described herein. Accordingly, this invention includes all modifications and equivalents of the subject matter recited in the claims appended hereto as permitted by applicable law. Moreover, any combination of the above-described elements in all possible variations thereof is encompassed by the invention unless otherwise indicated herein or otherwise clearly contradicted by context.

## Claims

1. An explosion resistant electrical fitting, comprising:
a cylindrical body, including:
a first end,
a second end opposite the first end,
an interior cavity extending from the first end to the second end,
a shoulder at the second end protruding radially outward relative to a central axis, and
a threaded surface;
a sealing ring arranged about the cylindrical body between the threaded surface and the shoulder of the cylindrical body;
a locking element arranged at the first end; and
a printed circuit board (PCB) arranged in the interior cavity of the cylindrical body.

2. The fitting according to claim 1, further comprising a first electrical interface and a second electrical interface each connected to the PCB, wherein the first electrical interface is configured to electrically connect the PCB to one or more first conductors at the first end of the cylindrical body, and wherein the second electrical interface is configured to electrically connect the PCB to one or more second conductors at the second end of the cylindrical body.

3. The fitting according to claim 1, wherein the first end of the cylindrical body includes recesses extending radially inward toward the central axis, wherein the first end of the cylindrical body includes an opening arranged at each of the recesses, each opening extending toward the second end of the cylindrical body, and wherein the openings are each configured to receive a fastener such that the locking element is secured against the cylindrical body by the fasteners.

4. The fitting according to claim 1, wherein the first end of the cylindrical body includes a locking element recess extending radially inward toward the central axis, and wherein the locking element includes a first locking tab extending radially inward, the first locking tab of the locking element being configured to fit in the locking element recess and thereby prevent motion of the locking element relative to the cylindrical body in a circumferential direction.

5. The fitting according to claim 1, wherein the locking element includes a second locking tab protruding axially and radially such that the second locking tab extends toward the second end of the cylindrical body when the locking element is arranged at the first end of the cylindrical body.

6. An explosion-resistant assembly, comprising:
a housing with a first chamber, a second chamber, and a bore between the first chamber and the second chamber, the bore having a first threaded surface;
a cylindrical body, including:
a first end,
a second end opposite the first end,
an interior cavity extending from the first end to the second end,
a shoulder at the second end protruding radially outward relative to a central axis, and
a second threaded surface;
a sealing ring arranged about the cylindrical body between the second threaded surface and the shoulder of the cylindrical body;
a locking element arranged at the first end; and
a printed circuit board (PCB) arranged in the interior cavity of the cylindrical body,
wherein the cylindrical body is arranged within the bore such that the first threaded surface is engaged with the second threaded surface, and
wherein the sealing ring is arranged between the cylindrical body and the bore such that a seal is formed between the cylindrical body and the bore.

7. The assembly according to claim 6, wherein the shoulder of the cylindrical body has an outer diameter that is larger than an inner diameter of the bore such that the cylindrical body cannot be inserted into the bore beyond the shoulder.

8. The assembly according to claim 6, wherein the locking element includes a locking tab protruding axially and radially such that the locking tab extends toward the second end of the cylindrical body when the locking element is arranged at the first end of the cylindrical body.

9. The assembly according to claim 8, wherein the housing includes a locking tab recess in the first chamber, the locking tab recess configured to receive the locking tab of the locking element.

10. The assembly according to claim 9, wherein the locking element is secured against the cylindrical body such that the locking element is rotationally constrained relative to the cylindrical body.

11. The assembly according to claim 6, further comprising a first electrical interface and a second electrical interface each connected to the PCB, wherein the first electrical interface is configured to electrically connect the PCB to one or more first conductors at the first end of the cylindrical body, and wherein the second electrical interface is configured to electrically connect the PCB to one or more second conductors at the second end of the cylindrical body.

12. The assembly according to claim 11, wherein the first conductors are arranged within the first chamber, wherein the second conductors are arranged within the second chamber, and wherein the PCB is configured to electrically bridge the first and second chambers.

13. The assembly according to claim 6, further comprising a sealing body arranged in the interior cavity of the cylindrical body and about the PCB.

14. The assembly according to claim 13, wherein the assembly is configured to prevent flame originating from an explosion in one of the first and second chambers to the other of the first and second chambers for a pressure difference of at least 1000 psi between the first and second chambers.

15. A method for providing an explosion-resistant electrical fitting between a first and second chamber, the method comprising:
providing a cylindrical body with a threaded surface and a radially outwardly protruding shoulder, a printed circuit board (PCB) arranged within the cylindrical body, and a sealing ring arranged about a circumferential periphery of the cylindrical body;
arranging the cylindrical body within a threaded bore between the first and second chambers by rotating the cylindrical body such that the threaded surface of the cylindrical body engages with the threaded bore; and
rotating the cylindrical body in a first rotational direction until the shoulder of the cylindrical body contacts an end stop formed at one end of the threaded bore.

16. The method according to claim 15, further comprising:
fixing a locking element to the cylindrical body opposite the shoulder such that the locking element is rotationally fixed to the cylindrical body, wherein the locking element includes a locking tab configured to engage a locking recess within one of the first and second chambers; and
rotating the cylindrical body in a second rotational direction opposite the first rotational direction until the locking tab is inserted into the locking recess.

17. The method according to claim 15, further comprising electrically connecting first conductors in the first chamber to the PCB and electrically connecting second conductors in the second chamber to the PCB.

18. The method according to claim 17, further comprising receiving input signals from one of the first and second conductors to the PCB and transmitting output signals based on the received input signals to the other of the first and second conductors via the PCB.
